# FASCICULE DE BREVET EUROPEEN

(11) **EP 3 477 698 B1**
(45) Date de publication et mention de la délivrance du brevet: **20.05.2020**
(21) Numéro de dépôt: 18202154.3
(22) Date de dépôt: 23.10.2018
(51) Int. Cl.: H01L 23/495, H01L 23/31

(54) **CIRCUIT INTÉGRÉ EN BOÎTIER QFN**
INTEGRIERTER SCHALTKREIS IN EINEM QFN-GEHÄUSE
INTEGRATED CIRCUIT IN QFN UNIT

(30) Priorité: 26.10.2017 FR 1760104
(43) Date de publication de la demande: 01.05.2019
(73) Titulaire: STMicroelectronics S.r.l., 20864 Agrate Brianza (MB) (IT); STMICROELECTRONICS (ROUSSET) SAS, 13790 Rousset (FR)
(72) Inventeur: VERSIGLIA, Felice, 13090 AIX EN PROVENCE (FR); PAVLIN, Antoine, 13540 PUYRICARD (FR); TAGLIAPIETRA, Claudio, 20149 MILAN (IT)
(74) Mandataire: Cabinet Beaumont

(56) Documents cités:
- DE-A1- 10 147 375
- US-A1- 2004 089 926
- US-A1- 2005 121 756
- US-A1- 2007 132 075

## Description

### Domaine

La présente description concerne de façon générale les circuits électroniques et, plus particulièrement, la réalisation de puces de circuits intégrés. La présente description s'applique plus particulièrement aux circuits électroniques en boîtier sans support ou grille de connexion.

### État de l'art antérieur

Les circuits intégrés sont généralement encapsulés dans des boîtiers. On connait différentes catégories de boîtiers qui dépendent principalement de la technique utilisée pour connecter des contacts de la puce en matériau semiconducteur à des bornes (plots, pattes, etc.) de raccordement à d'autres circuits et de la technique utilisée pour monter les circuits électroniques (circuit intégré en boîtier) sur un support (plaquette de circuit imprimé ou autre).

On distingue principalement trois grandes familles de boîtiers. Les boîtiers DIP (Dual Inline Package) ou QFP (Quad Flat Package), à grille de connexion (lead frame) dans lesquels la puce est rapportée sur une partie centrale d'une grille de connexion comportant des broches sortant du boîtier pour être brasées sur la plaquette de circuit imprimé. Les boîtiers BGA (Ball Grid Array) portant des billes de brasage en face inférieure. Les boîtiers QFN (Quad Flat No-lead) sans grille de connexion et comportant des contacts affleurant du boîtier pour être brasés sur la plaquette de circuit imprimé.

La présente description s'applique à des boîtiers de cette dernière famille QFN.

Le document US 2007/0132075 décrit une structure et un procédé pour des boîtiers QFN incluant des puces d'épaisseur fine.

Le document US 2004/0089926 décrit un dispositif semiconducteur ultra fin.

Le document US 2005/0121756 décrit une grille de connexion pour dispositif semiconducteur.

Le document DE 101 47 375 décrit un composant électronique avec une puce semiconductrice et son procédé de fabrication.

### Résumé

Un mode de réalisation réduit tout ou partie des inconvénients des boîtiers sans grille de connexion.

Un mode de réalisation propose une solution particulièrement adaptée à améliorer la tenue en cyclage thermique d'un circuit en boîtier QFN.

Ainsi, un mode de réalisation prévoit un circuit électronique comportant :
une puce semiconductrice ayant une épaisseur inférieure à 160 µm ; et
un boîtier à contacts affleurant dans lequel est encapsulée la puce, la puce occupant entre vingt-cinq et cinquante pourcents de la surface du boîtier.

Selon un mode de réalisation, la plus grande dimension linéaire de la puce représente au moins cinquante pourcents de la plus grande dimension linéaire du boîtier.

Selon un mode de réalisation, la plus grande dimension linéaire de la puce représente entre cinquante et soixante-dix pourcents de la plus grande dimension linéaire du boîtier.

Selon un mode de réalisation, la puce et le boîtier sont de surfaces rectangulaires, chacun des côtés de la puce représentant entre cinquante et soixante-dix pourcents du côté du boîtier avec lequel il est parallèle.

Selon un mode de réalisation, des fils conducteurs connectent, à l'intérieur du boîtier, des contacts en face supérieure de la puce en face supérieure d'au moins une partie desdits contacts affleurant.

Selon un mode de réalisation, la puce a une épaisseur (e) inférieure à 110 µm, de préférence inférieure à 70 µm.

Selon un mode de réalisation, le boîtier est en résine époxy.

Selon un mode de réalisation, le boîtier est de type sans grille de connexion.

Selon un mode de réalisation, le boîtier est de type QFN.

Selon un mode de réalisation, le circuit comporte :
un premier contact affleurant approximativement au centre de la face inférieure du boîtier ; et
plusieurs deuxièmes contacts affleurant répartis en périphérie de la surface inférieure du boîtier, les deuxièmes contacts affleurant en face inférieure et en périphérie du boîtier.

Selon un mode de réalisation, le premier contact reçoit, en face supérieure, la face inférieure de la puce.

Selon un mode de réalisation, un joint de soudure ou de colle est présent entre la puce et le premier contact.

Selon un mode de réalisation, la surface du premier contact est supérieure à la surface de la puce.

Selon un mode de réalisation, le premier contact occupe plus de soixante pourcents de la surface de la face inférieure du boîtier.

Selon un mode de réalisation, les deuxièmes contacts reçoivent, en face supérieure, des fils conducteurs de raccordement à des zones de reprise de contacts en face supérieure de la puce.

Selon un mode de réalisation, la face supérieure du boîtier est dépourvue de contacts.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B sont des vues respectivement de dessus et de dessous d'un mode de réalisation d'un circuit électronique en boîtier QFN ;
la figure 2 est une vue en coupe d'un circuit électronique en boîtier QFN usuel monté sur une plaquette de circuit imprimé ; et
la figure 3 est une vue en coupe schématique d'un mode de réalisation d'un circuit électronique en boîtier QFN.

### Description détaillée

De mêmes éléments ont été désignés par de mêmes références aux différentes figures.

Par souci de clarté, seuls les étapes et éléments utiles à la compréhension des modes de réalisation qui vont être décrits ont été représentés et seront détaillés. En particulier, les étapes de montage en boîtiers et de montage des boîtiers sur une plaquette de circuit imprimé n'ont été détaillées que pour les besoins de la présente description, les autres détails de fabrication et de montage étant compatibles avec les techniques usuelles de réalisation et d'utilisation de boîtiers QFN. De même, la fabrication des puces semiconductrices n'a pas été détaillée plus que nécessaire pour l'explication des modes de réalisation décrits, la fabrication faisant appel à des techniques en elles-mêmes usuelles. En outre, la ou les fonctions électroniques remplies par le circuit électronique n'ont pas été détaillées, les modes de réalisation décrits étant compatibles avec toute fonction usuelle d'un circuit électronique.

Sauf précision contraire, lorsque l'on fait référence à deux éléments connectés entre eux, cela signifie directement connectés sans élément intermédiaire autre que des conducteurs, et lorsque l'on fait référence à deux éléments reliés entre eux, cela signifie que ces deux éléments peuvent être directement reliés (connectés) ou reliés par l'intermédiaire d'un ou plusieurs autres éléments. Par ailleurs, lorsque l'on fait référence à des qualificatifs de position absolue, tels que "supérieur", "inférieur", etc., on se réfère sauf précision contraire à l'orientation des figures.

Dans la description qui suit, lorsqu'on fait référence aux termes "approximativement", "environ" et "de l'ordre de", cela signifie à dix pourcents près, de préférence à cinq pourcents près.

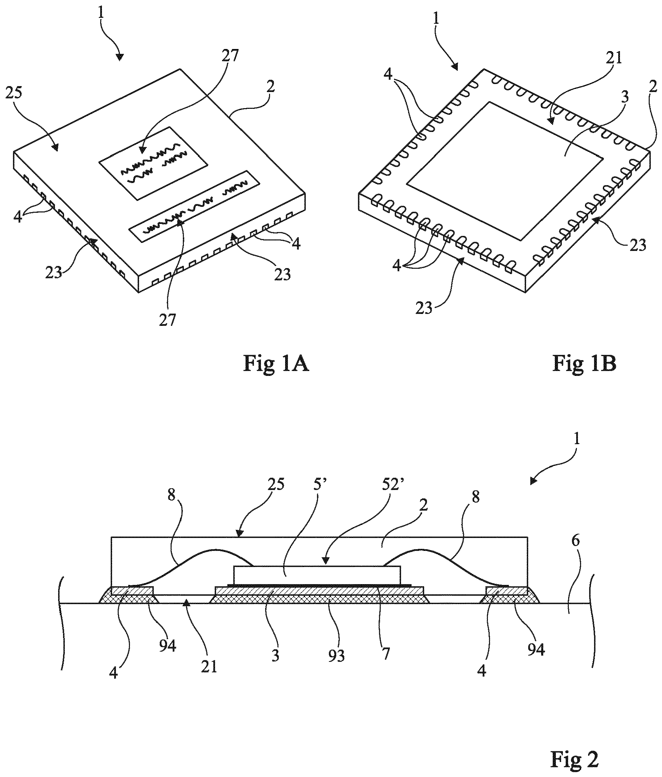

Les figures 1A et 1B sont des vues respectivement de dessus et de dessous d'un mode de réalisation d'un circuit électronique 1 en boîtier QFN 2.

Le circuit 1 comporte une puce de circuit intégré en matériau semiconducteur (non visible en figures 1A et 1B) et un boîtier 2, de type QFN.

Un boîtier QFN 2 est un boîtier sans grille de connexion et à contacts affleurant. Le boîtier 2 a la forme d'un parallélépipède rectangle ou carré et ne comporte pas d'excroissance par rapport à ses différences faces, de préférence planes.

En face inférieure 21 (la face visible au-dessus en figure 1B), le boîtier 2 comporte un premier contact affleurant 3 approximativement central, et plusieurs deuxièmes contacts périphériques affleurant 4. Les contacts périphériques 4 affleurent non seulement en face inférieure 21, mais également en face périphérique 23 du boîtier du côté de laquelle ils sont situés.

Le nombre de contacts périphériques 4 dépend du besoin de raccordement de la puce de circuit intégré. Généralement, les contacts 4 sont régulièrement répartis en périphérie avec un même nombre de contacts 4 sur chaque côté.

La face inférieure 21 est destinée à être rapportée sur un support de circuits électroniques, par exemple une plaquette de circuit imprimé (non représentée en figures 1A et 1B) . Les contacts 3 et 4 sont destinés à être brasés ou soudés sur des zones conductrices de cette plaquette, avec apport de brasure.

En face supérieure 25 (figure 1A), le boîtier 2 est généralement dépourvu de parties conductrices. La face supérieure 25 porte, le plus souvent, des inscriptions 27 identifiant le fabricant et/ou la nature du circuit électronique.

Le boîtier 2 est généralement principalement en résine époxy moulée autour des différents constituants.

La figure 2 est une vue en coupe d'un circuit électronique 1, en boîtier QFN usuel, monté sur une plaquette 6 de circuit imprimé.

On retrouve le boîtier 2 en résine époxy et, en face inférieure 21 les contacts affleurant 3 et 4. La figure 2 montre le montage de la puce, ici 5', en matériau semiconducteur, par sa face arrière ou inférieure, en face supérieure (interne au boîtier 2), du contact central 3. La puce 5' est brasée ou collée (joint de soudure ou de colle 7) en face supérieure du contact 3. Ainsi, la puce est liée au contact 3 de manière suffisamment rigide pour s'opposer à sa dilatation thermique naturelle. Les deuxièmes contacts 4 reçoivent, en face supérieure, des fils conducteurs 8 de raccordement à des zones de reprise de contact présentes en face supérieure 52' de la puce.

Le circuit 1 est monté sur la plaquette 6 par sa face inférieure 21. Les contacts 3 et 4 sont brasés (brasures 93 et 94) sur des zones métalliques non représentées de la plaquette 6. La destination de ces zones métalliques, par exemple de connexion à la masse, d'interconnexion à d'autres circuits électroniques, de connexion à des bornes d'entrée-sortie portées par la plaquette 6, etc. est usuelle et n'est pas modifiée par les modes de réalisation décrits.

Ce type de boîtier est adapté à des puces 5' dont la surface est relativement faible, typiquement qui représente moins de la moitié de la surface du boîtier et qui ne chauffent pas trop. Autrement, on rencontre un problème de fiabilité lié aux contraintes thermiques subies par la puce. En effet, le fait que le boîtier soit directement brasé sur la plaquette de circuit imprimé 6 engendre que les contraintes thermiques subies y compris par la plaquette 6 sont répercutées sur la puce. Dans un boîtier QFN, c'est-à-dire sans grille de connexion ou lead frame, les broches qui équipent habituellement un boîtier DIP ou QFP ne sont pas présentes pour absorber des dilatations. En particulier, en cas d'échauffement, la puce 5' reste rigide et empêche la dilatation du contact central 3. Cela conduit à ce que la plaquette 6 exerce un effort de cisaillement sur les soudures du contact 3 et des contacts 4 sur la plaquette 6, ce qui endommage le circuit électronique. Cela peut même dans certains cas provoquer un décollement de la puce du contact 3.

Ce problème est d'autant plus critique que la puce, donc le contact central 3, occupe une surface importante par rapport à la surface totale du boîtier. En pratique, cela limite la surface de la puce à environ vingt-cinq pourcents de la surface totale du boîtier pour des boîtiers subissant de fortes contraintes thermiques comme, par exemple, dans les applications de l'industrie automobile.

Selon les modes de réalisation décrits, on prévoit d'autoriser une déformation de la puce en matériau semiconducteur en diminuant son épaisseur.

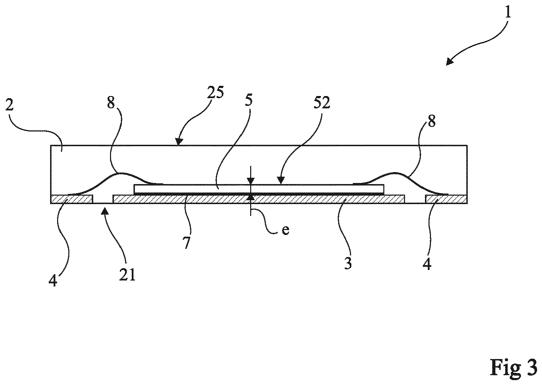

La figure 3 est une vue en coupe schématique d'un mode de réalisation d'un circuit électronique en boîtier QFN.

On retrouve un boîtier 2, de préférence en résine époxy et, en face inférieure 21 du boîtier des contacts affleurant, respectivement central 3 et périphériques 4. Une puce, ici 5, en matériau semiconducteur, est montée par sa face arrière ou inférieure, en face supérieure (interne au boîtier 2), du contact central 3. Cette face arrière de la puce 5 porte généralement un plan de masse, par lequel s'évacue en partie la chaleur. La puce 5 est brasée ou collée (joint 7) en face supérieure du contact 3. Les contacts périphériques 4 reçoivent, en face supérieure, des fils conducteurs 8 de raccordement à des zones de reprise de contact présentes en face supérieure 52 de la puce 5. Le reste, et notamment le montage sur une plaquette de circuit imprimé est usuel et tel que décrit plus haut.

Selon le mode de réalisation de la figure 3, la puce 5 est d'une épaisseur e plus fine que les puces 5' des circuits électroniques en boîtier QFN usuels. La puce 5 est suffisamment fine de sorte qu'elle suit les déformations thermiques de la plaquette de circuit imprimé qui sont répercutées par le contact central 3 du boîtier 2. Afin que cette diminution soit suffisante pour absorber plusieurs milliers de cycles, de préférence au moins deux mille cycles, de montée en température jusqu'à des températures de l'ordre de 100 à 150 degrés, de préférence de l'ordre de 125 °C, pour des circuits 1 dont la surface de la puce 5 représente plus de vingt-cinq pourcents de la surface du boîtier 2, on prévoit une épaisseur de puce 5 inférieure à 160 µm. Plus la puce 5 est fine, meilleure est la déformation mécanique.

L'amincissement s'effectue, de préférence, au niveau de la plaquette semiconductrice, avant que celle-ci ne soit découpée pour individualiser les puces de circuit intégré qu'elle comporte. Cet amincissement s'effectue typiquement par la face arrière de la plaquette dont les composants semiconducteurs sont réalisés en face avant. Ainsi, les solutions décrites s'appliquent, de préférence, à la réalisation de circuits intégrés dont les composants n'occupent qu'une partie de l'épaisseur de la plaquette semiconductrice.

Selon les modes de réalisation décrits, la surface occupée par la puce représente entre vingt-cinq et cinquante pourcents de la surface du boîtier.

De préférence, en termes de dimensions linéaires, c'est-à-dire, des dimensions horizontales (perpendiculaires à l'épaisseur), la plus grande dimension linaire de la puce représente au moins cinquante pourcents, et est de préférence comprise entre cinquante et soixante-dix pourcents, de la plus grande dimension linéaire du boîtier.

Selon un mode de réalisation, la puce et le boîtier sont rectangulaires (leurs surfaces principales sont rectangulaires). Chaque côté ou bord de la puce a alors une longueur représentant au moins cinquante pourcents, de préférence comprise entre cinquante et soixante-dix pourcents du côté ou bord du boîtier avec lequel il est parallèle.

En d'autres termes, les dimensions du boîtier sont choisies par rapport aux dimensions de la puce pour respecter les proportions ci-dessus.

Un avantage des modes de réalisation décrits est que la puce 5 peut suivre les déformations du contact central 3, ce qui atténue, voire supprime les contraintes mécaniques sur les joints de soudure (93 et 94 en figure 2) des contacts 3 et 4 sur la plaquette et sur le joint de soudure 7. Cet avantage est atteint non seulement par la faible épaisseur de la puce, mais également par la grande surface relative de la puce par rapport au boîtier par rapport aux solutions usuelles.

Un autre avantage est que cela rend les boîtiers QFN compatibles avec des applications, telles que les applications automobiles, dans lesquelles les contraintes thermiques sont importantes et/ou dans lesquelles les surfaces des puces représentent plus de vingt-cinq pourcents de la surface du boîtier.

Un autre avantage est que la diminution de l'épaisseur e de la puce autorise une diminution correspondante de l'épaisseur totale du boîtier 2, donc du circuit 1.

De préférence, la puce 5 occupe une surface représentant plus de vingt-cinq pourcents de la surface de la face inférieure 21 du boîtier 2. De préférence, le contact central 3 occupe une surface représentant au moins cinquante pourcents et de préférence plus de soixante pourcents de la surface inférieure 21 du boîtier 2.

A titre d'exemple particulier de réalisation, un circuit électronique tel que décrit ci-dessus comporte une puce 5 d'une surface comprise entre environ 10 mm² et environ 15 mm² et d'une épaisseur inférieure à 110 µm, de préférence de l'ordre de 70 µm.

Un autre avantage des modes de réalisation décrits est qu'ils ne requièrent pas de modification du processus de mise en boîtier proprement dite, ni de l'encapsulation, ni du montage du circuit en boîtier QFN sur une plaquette de circuit imprimé.

Divers modes de réalisation ont été décrits. Diverses modifications apparaîtront à l'homme de l'art. En particulier, le choix de la durée d'émission du champ peut varier d'une application à une autre. En outre, la mise en oeuvre pratique des modes de réalisation qui ont été décrits, et en particulier le choix de l'épaisseur finale et la technique d'amincissement de la plaquette en matériau semiconducteur dans laquelle sont réalisées les puces, est à la portée de l'homme du métier en utilisant les indications fonctionnelles donné ci-dessus.

## Revendications

1. Circuit électronique (1) comportant :
une puce semiconductrice (5) ayant une épaisseur (e) inférieure à 160 µm ; et
un boîtier (2) à contacts affleurant (3, 4) dans lequel est encapsulée la puce, le circuit électronique étant **caractérisée en ce que** la surface de la puce représente entre vingt-cinq et cinquante pourcents de la surface du boîtier.

2. Circuit selon la revendication 1, dans lequel, la plus grande dimension linéaire de la puce représente au moins cinquante pourcents de la plus grande dimension linéaire du boîtier.

3. Circuit selon la revendication 2, dans lequel la plus grande dimension linéaire de la puce représente entre cinquante et soixante-dix pourcents de la plus grande dimension linéaire du boîtier.

4. Circuit selon l'une quelconque des revendications 1 à 3, dans lequel la puce et le boîtier sont de surfaces rectangulaires, chacun des côtés de la puce représentant entre cinquante et soixante-dix pourcents du côté du boîtier avec lequel il est parallèle.

5. Circuit selon l'une quelconque des revendications 1 à 4, dans lequel des fils conducteurs (8) connectent, à l'intérieur du boîtier (2), des contacts en face supérieure de la puce (5) en face supérieure d'au moins une partie desdits contacts affleurant (4).

6. Circuit selon l'une quelconque des revendications 1 à 5, dans lequel la puce (5) a une épaisseur (e) inférieure à 110 µm, de préférence inférieure à 70 µm.

7. Circuit selon l'une quelconque des revendications 1 à 6, dans lequel le boîtier (2) est en résine époxy.

8. Circuit selon l'une quelconque des revendications 1 à 7, dans lequel le boîtier (2) est de type sans grille de connexion.

9. Circuit selon l'une quelconque des revendications 1 à 8, dans lequel le boîtier (2) est de type QFN.

10. Circuit selon l'une quelconque des revendications 1 à 9, comportant :
un premier contact (3) affleurant approximativement au centre de la face inférieure (21) du boîtier (2) ; et
plusieurs deuxièmes contacts affleurant (4) répartis en périphérie de la surface inférieure du boîtier (2), les deuxièmes contacts affleurant en face inférieure et en périphérie (23) du boîtier.

11. Circuit selon la revendication 10, dans lequel le premier contact (3) reçoit, en face supérieure, la face inférieure de la puce (5).

12. Circuit selon la revendication 11, dans lequel un joint de soudure ou de colle (7) est présent entre la puce (5) et le premier contact (3).

13. Circuit selon l'une quelconque des revendications 10 à 12, dans lequel la surface du premier contact (3) est supérieure à la surface de la puce (5).

14. Circuit selon l'une quelconque des revendications 10 à 13, dans lequel le premier contact (3) occupe plus de soixante pourcents de la surface de la face inférieure (21) du boîtier (2).

15. Circuit selon l'une quelconque des revendications 10 à 14, dans lequel les deuxièmes contacts (4) reçoivent, en face supérieure, des fils conducteurs (8) de raccordement à des zones de reprise de contacts en face supérieure (52) de la puce (5).

16. Circuit selon l'une quelconque des revendications 1 à 15, dans lequel la face supérieure (25) du boîtier (2) est dépourvue de contacts.

## Patentansprüche

1. Eine elektronische Schaltung (1), die Folgendes aufweist:
einen Halbleiterchip (5) mit einer Dicke (e) von weniger als 160 µm; und
ein Gehäuse (2) mit bündigen Kontakten (3, 4), in dem der Chip eingekapselt ist, wobei die elektronische Schaltung **dadurch gekennzeichnet ist, dass** die Oberfläche des Chips zwischen fünfundzwanzig und fünfzig Prozent der Oberfläche des Gehäuses ausmacht.

2. Schaltung nach Anspruch 1, wobei die größte lineare Dimension des Chips mindestens fünfzig Prozent der größten linearen Dimension des Gehäuses darstellt.

3. Schaltung nach Anspruch 2, wobei die größte lineare Dimension des Chips zwischen fünfzig und siebzig Prozent der größten linearen Dimension des Gehäuses ausmacht.

4. Schaltung nach einem der Ansprüche 1 bis 3, wobei der Chip und das Gehäuse rechteckige Oberflächen haben, wobei jede Seite des Chips zwischen fünfzig und siebzig Prozent der Seite des Gehäuses darstellt, zu der diese Seite parallel ist.

5. Schaltung nach einem der Ansprüche 1 bis 4, wobei leitende Drähte (8) im Inneren des Gehäuses (2) Kontakte an der Oberseite des Chips (5) mit der Oberseite mindestens eines Teils der bündig angeordneten Kontakte (4) verbinden.

6. Schaltung nach einem der Ansprüche 1 bis 5, wobei der Chip (5) eine Dicke (e) von weniger als 110 µm, vorzugsweise weniger als 70 µm, aufweist.

7. Schaltung nach einem der Ansprüche 1 bis 6, wobei das Gehäuse (2) aus Epoxidharz besteht.

8. Schaltung nach einem der Ansprüche 1 bis 7, wobei das Gehäuse (2) von dem Typ ist, der keinen Leiterrahmen aufweist.

9. Schaltung nach einem der Ansprüche 1 bis 8, wobei das Gehäuse (2) vom QFN-Typ ist.

10. Schaltung nach einem der Ansprüche 1 bis 9, die Folgendes aufweist:
einen ersten bündigen Kontakt (3) etwa in der Mitte der Unterseite (21) des Gehäuses (2); und
mehrere zweite bündige Kontakte (4), die am Umfang der Unterseite des Gehäuses (2) verteilt sind, wobei die zweiten Kontakte mit der Unterseite und mit dem Umfang (23) des Gehäuses bündig sind.

11. Schaltung nach Anspruch 10, wobei der erste Kontakt (3) an seiner Oberseite die Unterseite des Chips (5) aufnimmt.

12. Schaltung nach Anspruch 11, wobei eine Schweiß- oder Klebeverbindung (7) zwischen dem Chip (5) und dem ersten Kontakt (3) vorhanden ist.

13. Schaltung nach einem der Ansprüche 10 bis 13, wobei die Oberfläche des ersten Kontakts (3) größer ist als die Oberfläche des Chips (5).

14. Schaltung nach einem der Ansprüche 10 bis 13, wobei der erste Kontakt (3) mehr als sechzig Prozent der Oberfläche der Unterseite (21) des Gehäuses (2) einnimmt.

15. Schaltung nach einem der Ansprüche 10 bis 14, wobei die zweiten Kontakte (4) an ihrer Oberseite leitende Drähte (8) zur Verbindung mit Kontaktbereichen an der Oberseite (52) des Chips (5) erhalten bzw. aufnehmen.

16. Schaltung nach einem der Ansprüche 1 bis 13, wobei die Oberseite (25) des Gehäuses (2) keine Kontakte aufweist.

## Claims

1. An electronic circuit (1) comprising:
a semiconductor chip (5) having a thickness (e) smaller than 160 µm; and
a package (2) with flush contacts (3, 4) having the chip encapsulated therein, the electronic circuit being **characterized in that** the surface area of the chip represents between twenty-five percent and fifty percent of the surface area of the package.

2. The circuit of claim 1, wherein the largest linear dimension of the chip represents at least fifty percent of the largest linear dimension of the package.

3. The circuit of claim 2, wherein the largest linear dimension of the chip represents between fifty and seventy percent of the largest linear dimension of the package.

4. The circuit of any one of claims 1 to 3, wherein the chip and the package have rectangular surface areas, each side of the chip representing between fifty and seventy percent of the side of the package with which this side is parallel.

5. The circuit of any one of claims 1 to 4, wherein conductive wires (8) connect, inside of the package (2), contacts at the upper surface of the chip (5) to the upper surface of at least part of said flush contacts (4).

6. The circuit of any of claims 1 to 5, wherein the chip (5) has a thickness (e) smaller than 110 µm, preferably smaller than 70 µm.

7. The circuit of any of claims 1 to 6, wherein the package (2) is made of epoxy resin.

8. The circuit of any of claims 1 to 7, wherein the package (2) is of the type comprising no lead frame.

9. The circuit of any of claims 1 to 8, wherein the package (2) is of QFN type.

10. The circuit of any of claims 1 to 9, comprising:
a first flush contact (3) approximately at the center of the lower surface (21) of the package (2); and
a plurality of second flush contacts (4) distributed at the periphery of the lower surface of the package (2), the second contacts being flush with the lower surface and with the periphery (23) of the package.

11. The circuit of claim 10, wherein the first contact (3) receives, at its upper surface, the lower surface of the chip (5) .

12. The circuit of claim 11, wherein a welding or glue joint (7) is present between the chip (5) and the first contact (3) .

13. The circuit of any of claims 10 to 13, wherein the surface area of the first contact (3) is larger than the surface area of the chip (5).

14. The circuit of any of claims 10 to 13, wherein the first contact (3) takes up more than sixty percent of the surface area of the lower surface (21) of the package (2).

15. The circuit of any of claims 10 to 14, wherein the second contacts (4) receive, at their upper surface, conductive wires (8) of connection to contacting areas at the upper surface (52) of the chip (5).

16. The circuit of any of claims 1 to 13, wherein the upper surface (25) of the package (2) comprises no contacts.
